# EUROPÄISCHE PATENTSCHRIFT

(11) **EP 0 776 987 B1**
(45) Veröffentlichungstag und Bekanntmachung des Hinweises auf die Patenterteilung: **26.05.1999**
(21) Anmeldenummer: 96113894.8
(22) Anmeldetag: 30.08.1996
(51) Int. Cl.: C23C 14/32, C23C 14/02, C23C 14/56

(54) **Vakuumbeschichtungsanlage mit einem in der Vakuumkammer angeordneten Tiegel zur Aufnahme von zu verdampfendem Material**
Vacuum coating apparatus with a crucible located in the vacuum chamber to receive the evaporation material
Appareillage de revêtement sous vide avec un creuset pour recevoir le matériau à évaporer dans la chambre à vide

(30) Priorität: 30.11.1995 DE 19544584
(43) Veröffentlichungstag der Anmeldung: 04.06.1997
(73) Patentinhaber: Balzers und Leybold Deutschland Holding AG, 63450 Hanau (DE)
(72) Erfinder: Szczyrbowski, Joachim, Dr., 63773 Goldbach (DE); Teschner, Götz, 63450 Hanau (DE); Zöller, Alfons, 63628 Bad Soden-Salmünster (DE)

(56) Entgegenhaltungen:
- EP-A- 0 570 618
- DE-C- 4 343 042

## Beschreibung

Die Erfindung betrifft eine Vakuumbeschichtungsanlage mit einem in einer Vakuumkammer angeordneten Tiegel zur Aufnahme von zu verdampfendem Material, beispielsweise von SiO₂ und mit einer das Material verdampfenden Elektronenstrahlquelle und mit einem in einem Abstand zum Tiegel gehaltenen Substrat, beispielsweise einer optischen Linse.

Bekannt ist eine Vakuumbeschichtungsanlage (DE-A-42 03 632) mit einem Behälter, in dem sich ein zu verdampfendes Material befindet, mit einer Verdampfervorrichtung zum Verdampfen des in dem Behälter befindlichen Materials, wobei das zu beschichtende Material sich in einem Abstand von dem zu verdampfenden Material befindet, und mit einem Mikrowellensender, der Mikrowellen in den Raum zwischen dem zu verdampfenden Material und dem zu beschichtenden Material sendet.

Diese bekannte Anlage ermöglicht es, die Eigenschaften einer Metalloxid-Beschichtung auf einer Kunststoffolie zu verbessern.

Es ist auch eine Vorrichtung zum Aufstäuben eines dünnen Films bekannt, bei der die Geschwindigkeit des Niederbringens von Schichten unterschiedlicher Materialien regelbar ist (DE-A-39 12 572), um so zu extrem dünnen Schichtpaketen zu gelangen, wozu mindestens zwei unterschiedliche Arten von kathodenseitig vorgesehenen Gegenelektroden angeordnet sind.

Weiterhin ist eine Anordnung zum Abscheiden einer Metalllegierung mit Hilfe von HF-Kathodenzerstäubung bekannt (DE-A-35 41 621), bei der abwechselnd zwei Targets angesteuert werden, wobei die Targets die Metallkomponenten der abzuscheidenden Metallegierung jedoch mit unterschiedlichen Anteilen enthalten. Die Substrate sind zu diesem Zweck auf einem Substratträger angeordnet, der von einer Antriebseinheit während des Zerstäubungsvorgangs in Rotation versetzt wird.

Es ist außerdem bekannt (DE-A-38 02 852), bei einer Einrichtung für die Beschichtung eines Substrats mit zwei Elektroden und wenigstens einem zu zerstäubenden Material das zu beschichtende Substrat zwischen den beiden Elektroden in einem räumlichen Abstand anzuordnen und die Wechselstrom-Halbwellen als niederfrequente Halbwellen mit im wesentlichen gleichen Amplituden zu wählen.

Weiterhin ist eine Vorrichtung zum Beschichten eines Substrats, insbesondere mit nichtleitenden Schichten von elektrisch leitfähigen Targets in reaktiver Atmosphäre vorgeschlagen worden (DE-A-42 04 999), bestehend aus einer Stromquelle, die mit in einer evakuierbaren Beschichtungskammer angeordneten, Magnete einschließenden Kathoden verbunden ist, die elektrisch mit den Targets zusammenwirken, wobei zwei elektrisch voneinander und von der Sputterkammer getrennte Anoden angeordnet sind, die in einer Ebene zwischen den Kathoden und dem Substrat vorgesehen sind, wobei die beiden Ausgänge der Sekundärwicklung eines mit einem Mittelfrequenzgenerator verbundenen Transformators jeweils an eine Kathode über Versorgungsleitungen angeschlossen sind, wobei die erste und die zweite Versorgungsleitung über eine Zweigleitung untereinander verbunden sind, in die ein Schwingkreis, vorzugsweise eine Spule und ein Kondensator, eingeschaltet sind, und wobei jede der beiden Versorgungsleitungen jeweils sowohl über ein das Gleichspannungspotential gegenüber Erde einstellendes erstes elektrisches Glied mit der Beschichtungskammer als auch über ein entsprechendes zweites elektrisches Glied mit der jeweiligen Anode und über jeweils eine Zweigleitung mit eingeschaltetem Kondensator mit der Beschichtungskammer verbunden ist und wobei eine Drosselspule in den den Schwingkreis mit dem zweiten Sekundäranschluß verbindenen Abschnitt der ersten Versorgungsleitung eingeschaltet ist.

Darüber hinaus ist Kathodenzerstäubungsvorrichtung bekannt (DE-A-38 30 478) bei der die Vakuumkammer mit einer Einrichtung zur Erzeugung eines Plasmastrahls verbunden ist und ein Target aufweist, das mit Magneten zusammenwirkt, die den Plasmastrahl auf die Oberfläche des Targets lenken und mit einer Einrichtung versehen ist, um Ionen im Plasmastrahl zu beschleunigen, die die Oberfläche des Targets treffen und Teilchen herauslösen und Substrathalter aufweist, die im Inneren der Vakuumkammer zur Halterung der Substrate für die Beschichtung mit abgestäubten Teilchen angeordnet sind und vorzugsweise mit einer Einrichtung, beispielsweise einer Magnetanordnung ausgestattet ist für die Ablenkung zumindest eines Fadens oder Teilstrahls des Plasmastrahls vom Target auf das Substrat.

Die DE-C-4 343 042 beschreibt eine Vakuumbeschichtungsanlage zum plasmaaktivierten Bedampfen von Substraten mit einer im Vakuum angeordneten Verdampfungseinrichtung zum direkten oder indirekten Verdampfen des Verdampfungsgutes, Elektroden, deren wirksame Oberfläche von einem magnetischen Feld nach Art einer Magnetronkathode durchdrungen sind und wobei die Elektroden im Raum zwischen den Substraten und dem Verdampfungsmaterial angeordnet sind, einer Spannungsquelle zur Aufrechterhaltung einer nichtthermischen Entladung zur Plasmaerzeugung, und Mittel zum Einlassen von Gasen im Raum zwischen dem Verdampfungsmaterial und den Substraten.

Die EP-A-0 570 618 beschreibt eine Vakuumbeschichtungsanlage mit einem in einer Vakuumkammer angeordneten Tiegel zur aufnahme von zu verdampfendem Material und mit einer das Material verdampfenden Elektronenstrahlquelle und mit in einem Abstand zum Tiegel gehaltenem Substrat, wobei in der Zone zwischen dem Substrat und dem Tiegel eine Ionenquelle vorgesehen ist.

Schließlich ist ein Verfahren bekannt (DE-C-44 12 906) für die ionengestützte Vakuumbeschichtung, vorzugsweise für die Hochratenbeschichtung großflächiger, elektrisch leitfähiger oder elektrisch isolierender Substrate mit elektrisch isolierenden Schichten und elektrisch isolierender Substrate mit elektrisch leitenden Schichten, indem zwischen einer Beschichtungsquelle und dem Substrat ein Plasma erzeugt wird, aus welchem Ionen in Richtung auf das Substrat beschleunigt werden, wobei an das elektrisch leitfähige Substrat oder an eine unmittelbar hinter dem elektrisch isolierenden Substrat angeordnete, sich über die gesamte Beschichtungsfläche erstreckende Elektrode abwechselnd negative und positive Spannungsimpulse relativ zum Plasma angelegt werden, daß die Dauer der negativen Impulse der Aufladezeit des sich über die isolierende Schicht und/oder das isolierende Substrat ausbildenden Kondensators angepaßt wird, daß die Dauer der positiven Impulse höchstens gleich, vorzugsweise 2- bis 10-mal kleiner als die Dauer der negativen Impulse gewählt wird, daß die positiven und negativen Impulse unmittelbar aneinander anschließen und annähernd auf die gleiche Höhe relativ zum Basispotential eingestellt werden, und daß die Höhe der Impulse relativ zum Basispotential ± 20 bis ± 2000 V, vorzugweise ± 50 bis ± 500 V, eingestellt wird.

Transparente Kunststoffolien werden im verstärkten Maße für die Verpackung von Lebensmitteln eingesetzt. In erster Linie kommen hierbei Folien aus Polymer-Kunststoffen in Frage, die zwar flexibel sind, aber den Nachteil aufweisen, für Aromastoffe, Wasser oder Sauerstoff durchlässig zu sein. Wenn eine Diffusion solcher Stoffe ausgeschlossen werden soll, werden deshalb im allgemeinen Aluminiumfolien oder Kunststoffolien mit aufgedampftem Aluminium verwendet. Diese haben jedoch den Nachteil, daß sie relativ schwer zu entsorgen und für Mikrowellen und Licht nicht durchlässig sind. Durch die Verbreitung von Mikrowellenherden in vielen Haushalten der industrialisierten Länder ist die Mikrowellendurchlässigkeit des Verpakkungsmaterials in vielen Fällen von Bedeutung.

Um die Vorteile der Kunststoffolien, die für die Mikrowellen durchlässig sind, mit den Vorteilen der Aluminiumfolien, die eine absolute Sperre für Aromastoffe, Wasser und Sauerstoff bilden, zu vereinigen, ist es bereits bekannt, Polymer-Folien mit Oxiden zu beschichten. Hierbei spielt Siliziumoxid als Beschichtungsmaterial eine besondere Rolle. Die mit Siliziumoxid beschichteten Kunststoffolien haben bezüglich der Laminatstruktur und dem Barriereverhalten gegenüber Sauerstoff, Wasserdampf und Aroma ähnliche Eigenschaften wie Aluminiumfolie oder mit Aluminium beschichtete Kunststoffolien.

Die Beschichtung von Kunststoffolien mit Metalloxiden wie SiOₓ erfordert jedoch eine Prozeßtechnik, die sich stark von den üblichen Beschichtungstechniken unterscheidet, weil Metalloxide im Gegensatz zu Metallen aus der festen Phase heraus verdampft werden müssen.

Die Herstellung von SiOₓ-Schichten erfolgt durch das Verdampfen von SiO mittels eines Verdampfungsofens oder mittels Elektronenstrahl-Verdampfung (vgl. T. Krug, K. Rübsam: Die neue "gläserne Lebensmittelverpackung" in "neue Verpackung", Hüthig-Verlag, 1991). SiOₓ-Schichten haben den Vorteil, daß sie leicht biegbar sind. Außerdem ist SiOₓ chemisch inert und korrosionsbeständig gegen Wasser. SiO kann ebenso wie Mgo, Al₂O₃ oder SiO₂ mit Hilfe eines Elektronenstrahls verdampft werden, da es einen relativ hohen Dampfdruck hat.

Der vorliegenden Erfindung liegt die Aufgabe zugrunde, eine Vakuumbeschichtungsanlage zu schaffen, die eine Beschichtung von Folien, insbesondere Verpackungsfolien, mit transparenten Barriereschichten mit hoher Rate und Qualität ermöglicht. Die Anlage soll trotz der sich abscheidenden parasitären oxydischen Schichten eine hohe Standzeit aufweisen und eine hohe Prozeßstabilität ermöglichen.

Gemäß der Erfindung wird diese Aufgabe dadurch gelöst,daß beiderseits einer Verbindungslinie zwischen dem Tiegel und dem Substrat halter je ein Abteil angeordnet ist, in dem jeweils eine mit einer Mittelfrequenzstromquelle verbundene Magnetronkathode vorgesehen ist, wobei jede der beiden Abteile über jeweils einen Kanal mit der Zone bzw. dem Prozeßraum zwischen dem Substrat und dem Tiegel verbunden ist, wobei die Targets der Magnetronkathoden auf die den Kanälen abgekehrten Wandpartien der Abteile ausgerichtet sind, und wobei beide Abteile jeweils über Druckmittelleitungen an eine Quelle für ein Prozeßgas angeschlossen sind.

Weitere Einzelheiten und Merkmale sind in den Patentansprüchen näher beschrieben und gekennzeichnet.

Die Erfindung läßt die verschiedensten Ausführungsmöglichkeiten zu; zwei davon sind in den anhängenden Zeichnungen rein schematisch näher dargestellt, die Vakuumbeschichtungsanlagen für optische Elemente im Schnitt zeigen.

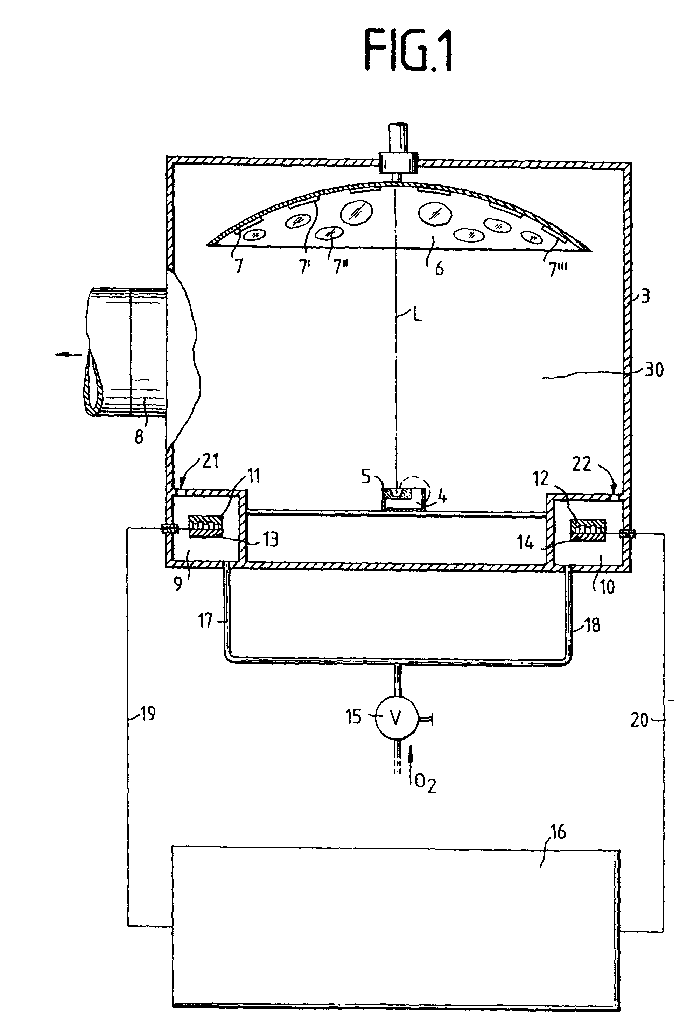

In Figur 1 ist eine Vakuumanlage dargestellt, bestehend aus einer Vakuumkammer 3, einem mit einer Elektronenstrahlquelle 4 zusammenwirkenden Tiegel 5, einem oberhalb des Tiegels 5 vorgesehenen Substrathalter 6 mit Substraten 7, 7', ..., einem Anschluß 8 für eine Vakuumpumpe, zwei Abteile 9, 10 mit in diesen angeordneten Sputterkathoden 11, 12, deren Targets 13, 14, jeweils auf die dem Substratträger 6 abgekehrten Seitenwände ausgerichtet sind, einer Prozeßquelle 15, die über Gasleitungen 17, 18 an die Abteile 9, 10 angeschlossen ist und einer Mittelfrequenz-Stromversorgung 16, die über Stromleitungen 19, 20 mit den Kathoden 13, 14 verbunden ist.

Die Kathoden 13, 14 sind in von der Vakuumkammer 3 abgetrennten Abteilen 9, 10 untergebracht. Die Sputterrichtung der beiden Magnetronkathoden 11, 12 ist so gewählt, daß sich die abgesputterten Teilchen in Richtungen ausbreiten, die von den Substraten 7, 7', ..., abgewandt sind. Die Abteile 9, 10 sind so gestaltet, daß die Teilchen, die von den Magnetronkathoden abgeschieden werden, in den Abteilen aufgefangen werden.

Je nach gewünschter Druckdifferenz zwischen den Abteilen 9, 10 und dem Prozeßraum 30 können die Vakuumkammer 3 und jedes Abteil 9, 10 über einen Spalt 21, 22 als Druckstufe verbunden werden. Die Kathoden werden in ihren Abteilen jeweils durch einen Gaseinlaß mit dem Arbeitsgas, typisch Argon und Sauerstoff, versorgt. Der Druck in den Abteilen wird so gewählt, daß die Magnetentladung stabil brennt.

Jedes Magnetron 11, 12 trägt ein Target 13, 14, das in diesem Falle unerwünscht zerstäubt wird. Aus diesem Grunde wird ein Targetmaterial gewählt, das eine niedrige Zerstäubungsrate hat und/oder Zerstäubungsprodukte liefert, die bei dem Aufdampfprozeß nicht stören. Im Falle von sauerstoffhaltiger Atmosphäre bietet sich Graphit als Targetmaterial an. Der Kohlenstoff verbrennt beim Zerstäuben und das CO₂ wird abgepumpt.

Die beiden Kathoden 11, 12 sind mit einer Wechselstromversorgung 16 verbunden. Eine Ausführungsform dieser Stromversorgung ist in der DE-A- 41 38 793 beschrieben.

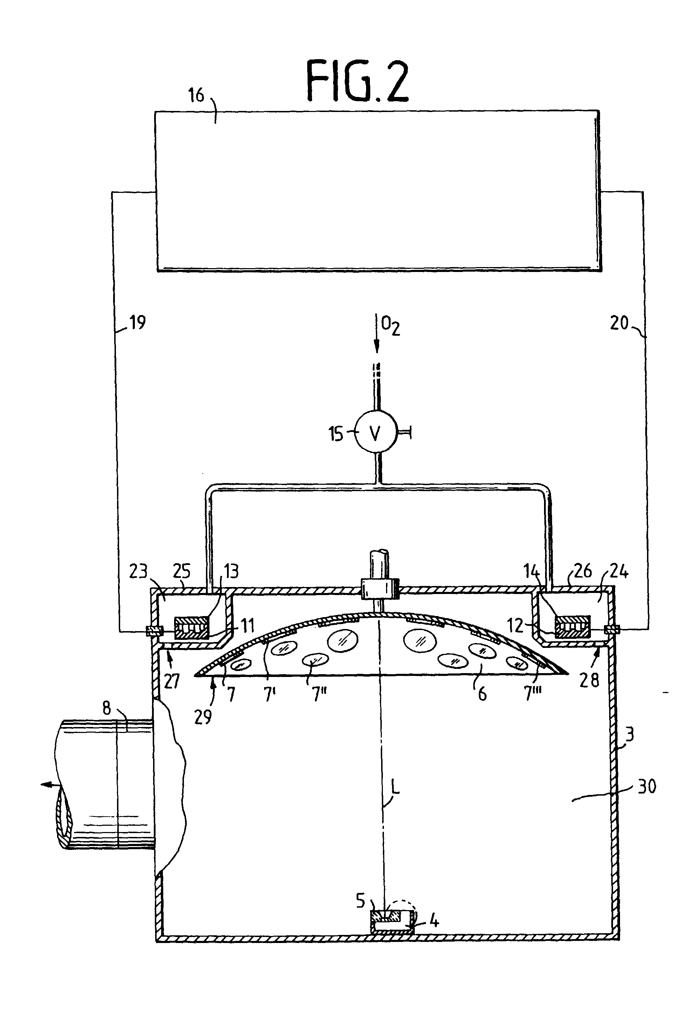

Die Ausführungsform gemäß Figur 2 unterscheidet sich im wesentlichen von derjenigen nach Figur 1 dadurch, daß die Abteile 23, 24 sich in der Ebene der Substrate 7, 7', ..., befinden, wobei die Targets 13, 14 der Kathoden 11, 12 auf die oberen Wandpartien 25, 26 der Abteile 23, 24 ausgerichtet sind und die Spalte oder Kanäle 27, 28 etwa im Bereich des unteren Randes 29 des schirmförmigen Substrathalters 6 in die Prozeßkammer einmünden.

Die Anlagen gemäß den Figuren 1 und 2 haben den Vorteil ein breites Plasmaband mit Hilfe kalter Kathoden 11, 12 zur Ionenunterstützung, insbesondere bei SiO₂ Beschichtungen, z. B. von Brillengläsern zu liefern. Die vorbekannte APS-Quelle (DE -A-38 32 693, DE-A- 38 30 478) zum ionenunterstützten Elektronenstrahlverdampfen arbeitet mit Glühkathoden, die den Nachteil aufweisen, empfindlich gegen "Vergiftungen" zu sein, d. h. die APS liefert nach Einwirkung von schädlichen Gasen oder zu viel Sauerstoff nicht mehr den benötigten Emissionsstrom. Darüber hinaus verschleißt eine Glühkathode relativ schnell und muß in kurzen Abständen gewechselt werden. Glühkathoden werden durch das Ionenbombardement auch abgetragen, so daß die aufgedampfte Schicht mit dem Kathodenmaterial verunreinigt wird. Schließlich ist auch die Wahl des Kathodenmaterials begrenzt, da ein Material benötigt wird, das in der Aufdampfatmosphäre eine genügend große Elektronenemission hat (z. B. wird LₐB₆ verwendet) . Schließlich ist die APS eine Punktquelle, die immer im großen Abstand von den Substraten angeordnet sein muß, um eine genügend gleichmäßige Ionenverteilung zu erreichen.

### Bezugszeichenliste

- 3: Vakuumkammer
- 4: Elektronenstrahlquelle
- 5: Tiegel
- 6: Substrathalter
- 7, 7': Substrat
- 8: Pumpenanschluß
- 9: Kammer, Abteil
- 10: Kammer, Abteil
- 11: Kathode
- 12: Kathode
- 13: Target
- 14: Target
- 15: Prozeßgasquelle
- 16: Mittelfrequenz-Stromversorgung
- 17: Gasleitung
- 18: Gasleitung
- 19: Stromleitung
- 20: Stromleitung
- 21: Spalt, Kanal
- 22: Spalt, Kanal
- 23: Kammer, Abteil
- 24: Kammer, Abteil
- 25: Wandpartie
- 26: Wandpartie
- 27: Spalt, Kanal
- 28: Spalt, Kanal
- 29: Substrathalter-Rand
- 30: Prozeßraum

## Patentansprüche

1. Vakuumbeschichtungsanlage mit einem in einer Vakuumkammer (3) angeordneten Tiegel (5) zur Aufnahme von zu verdampfendem Material, beispielsweise von SiO₂ und mit einer das Material verdampfenden Elektronenstrahlquelle (4) und mit in einem Abatand zum Tiegel (5) gehaltenen Substraten (7, 7', ...), beispielsweise optischen Linsen, wobei beiderseits einer Verbindungslinie (L) zwischen dem Tiegel (5) und dem Substrathalter (6) je ein Abteil (9, 10 bzw. 23, 24) angeordnet ist, in dem jeweils eine mit einer Mittelfrequenzquelle (16) verbundene Magnetronkathode (11, 12) vorgesehen ist, wobei jedes der beiden Abteile (9, 10 bzw. 23, 24) jeweils über einen Kanal (21, 22 bzw. 27, 28) mit der Zone bzw. dem Prozeßraum (30) zwischen dem Substrat (7, 7', ...) und dem Tiegel (5) verbunden ist, wobei die Targets (13,14) der Magnetronkathoden (11, 12) auf die den Kanälen (21, 22 bzw. 27, 28) abgekehrten Wandpartien der Abteile (9, 10) ausgerichtet sind, und wobei beide Abteile (9, 10 bzw. 23, 24) jeweils über Druckmittelleitungen (19, 20) an eine Quelle (15) für ein Prozeßgas angeschlossen sind.

2. Vakuumbeschichtungsanlage nach Anspruch 1, **dadurch gekennzeichnet**, daß die Abteile (9, 10) für die Magnetron-Kathoden (11, 12) unterhalb des Substrathalters (6) angeordnet sind, wobei die die Abteile (9, 10) mit dem Prozeßraum (30) verbundenen Kanäle (21, 22) etwa in der Ebene des Tiegels (5) einmünden.

3. Vakuumbeschichtungsanlage nach Anspruch 1, **dadurch gekennzeichnet**, daß die Abteile (23, 24) für die Magnetron-Kathoden (11, 12) oberhalb des Tiegels (5) angeordnet sind, wobei die die Abteile (23, 24) mit dem Prozeßraum (30) verbindenden Kanäle (27, 28) etwa in der Ebene des Substrathalters (6) einmünden.

4. Vakuumbeschichtungsanlage nach einem oder mehreren der vorhergehenden Ansprüche, **da****durch gekennzeichnet**, daß der Flächenschwerpunkt des Substrathalters (6) von einer Lotrechten (L) geschnitten wird, die senkrecht zum Schmelzenspiegel des Tiegels (5) verläuft, wobei der Substrathalter (6) etwa die Form eines Schirms ausweist.

## Claims

1. Vacuum coating apparatus with a crucible (5) arranged in a vacuum chamber (3) to receive material to be evaporated, such as SiO₂ for example, and with an electron beam source (4) evaporating the material and with substrates (7, 7', ...) held at a distance from the crucible (5), such as optical lenses for example, wherein a compartment (9, 10 and/or 23, 24) is arranged in each case on either side of a connecting line (L) between the crucible (5) and the substrate holder (6), in each of which compartments a magnetron cathode (11, 12) connected to a medium frequency power source (16) is provided, wherein each of the two compartments (9, 10 and/or 23, 24) is connected to the zone and/or the process chamber (30) between the substrate (7, 7', ...) and the crucible (5) by means of a duct (21, 22 and/or 27, 28) in each case, wherein the targets (13, 14) of the magnetron cathodes (11, 12) are directed onto the wall parts of the compartments (9, 10) facing away from the ducts (21, 22 and/or 27, 28), and wherein both compartments (9, 10) and/or 23, 24) are connected in each case to a source (15) for a process gas by means of pressure means lines (19, 20).

2. Vacuum coating apparatus according to Claim 1, characterized in that the compartments (9, 10) for the magnetron cathodes (11, 12) are arranged under the substrate holder (6), wherein the ducts (21, 22) connecting the compartments (9, 10) to the process chamber (30) open approximately into the plane of the crucible (5) .

3. Vacuum coating apparatus according to Claim 1, characterized in that the compartments (23, 24) for the magnetron cathodes (11, 12) are arranged above the crucible (5), wherein the ducts (27, 28) connecting the compartments (23, 24) to the process chamber (30) open approximately into the plane of the substrate holder (6).

4. Vacuum coating apparatus according to one of the preceding Claims, characterized in that the surface centre of gravity of the substrate holder (6) is intersected by a vertical (L) which runs perpendicular to the melting surface of the crucible (5), wherein the substrate holder (6) approximately has the shape of an umbrella.

## Revendications

1. Appareillage de revêtement sous vide comportant un creuset (5), disposé dans une chambre sous vide (3), pour recevoir du matériau à vaporiser, par exemple du SiO₂, et comportant une source de faisceaux d'électrons (4) vaporisant le matériau et comportant des substrats (7, 7', ...), par exemple des lentilles optiques, maintenus à une certaine distance du creuset (5), dans lequel, de chacun des deux côtés d'une ligne de liaison (L) entre le creuset (5) et le porte-substrat (6) est disposé un compartiment (9, 10 ou 23, 24) dans chacun desquels est prévue une cathode de magnétron (11, 12) reliée à une source à moyenne fréquence (16), dans lequel chacun des deux compartiments (9, 10 ou 23, 24) est respectivement relié, par l'intermédiaire d'un canal (21, 22 ou 27, 28) avec la zone ou l'espace de processus (30) existant entre le substrat (7, 7', ...) et le creuset (5), dans lequel les cibles (13, 14) des cathodes de magnétron (11, 12) sont orientées vers les parties de paroi des compartiments (9, 10) opposées aux canaux (21, 22 ou 27, 28) et dans lequel chacun des deux compartiments (9, 10 ou 23, 24) est relié, par l'intermédiaire de conduites de fluide sous pression (19, 20) à une source (15) de gaz de processus.

2. Appareillage de revêtement sous vide selon la revendication 1, caractérisé par le fait que les compartiments 9, 10 pour les cathodes de magnétron (11, 12) sont disposés en-dessous du porte-substrat (6), les canaux (21, 22) reliant les compartiments (9, 10) avec l'espace de processus (30) débouchant à peu près dans le plan du creuset (5).

3. Appareillage de revêtement sous vide selon la revendication 1, caractérisé par le fait que les compartiments (23, 24) pour les cathodes de magnétron (11, 12) sont disposés au-dessus du creuset (5), les canaux (27, 28) reliant les compartiments (23, 24) à l'espace de processus (30) débouchant à peu près dans le plan du porte-substrat (6).

4. Appareillage de revêtement sous vide selon l'une ou plusieurs des revendications précédentes, caractérisé par le fait que par le centre de gravité de la surface du porte-substrat (6) passe une perpendiculaire (6) qui est orientée perpendiculairement à la surface du bain de fusion du creuset (5), le porte-substrat (6) présentant à peu près la forme d'un parapluie.
